# EUROPÄISCHE PATENTANMELDUNG

(11) **EP 1 748 495 A1**
(43) Veröffentlichungstag der Anmeldung: **31.01.2007**
(21) Anmeldenummer: 06015098.4
(22) Anmeldetag: 20.07.2006
(51) Int. Cl.: H01L 31/18, H01L 31/05

(54) **Verfahren und Vorrichtung zum Herstellen eines Solarzellenstrings durch induktives Löten**

(30) Priorität: 26.07.2005 DE 102005036130
(71) Anmelder: Somont GmbH, 79108 Freiburg (DE); Ernst Knoll Feinmechanik GmbH, 79224 Umkirch (DE)
(72) Erfinder: Knoll, Gerd, 79224 Umkrich (DE)
(74) Vertreter: Fuhlendorf, Jörn

(57) **Zusammenfassung**

Bei einem Verfahren zum Herstellen eines Solarzellenstring (11) aus mehreren aneinander gereihten, mit Lötbändern (14) elektrisch in Reihe geschalteten und mechanisch verbundenen Solarzellen (12,12'), insbesondere Siliziumnzellen, worden die Lötbänder (14) an ihren, den Solarzellen (12,12') zugewandten Flächen (16,17) mit Lötzinn überzogen und abwechselnd auf die Oberseite (16) und auf die Unterseite (17) zweier benachbarter Solarzellen (12,12') gelegt, und die so vorbereitete Solarzellenanordnung (11) wird über eine oder mehrere Vorheizzonen (22) geführt und am Ende zu einem Solarzellenstring (11) verlötet. Um ein Zusetzen der Schmelz- bzw. Lötvorrichtung und damit eine verschlechterte Wärmeübertragung von der Lötvorrichtung zu den zu verlötenden Bauteilen zu vermeiden ist vorgesehen, dass die Lötbänder und die Solarzellen durch Induktionslöten miteinander verbunden werden.

## Beschreibung

Die vorliegende Erfindung bezieht sich auf ein Verfahren zum Herstellen eines Solarzellenstring aus mehreren aneinandergereihten, mit Lötbändern elektrisch in Reihe geschalteten und mechanisch verbundenen Solarzellen, insbesondere Siliziumzellen, nach dem Oberbegriff des Anspruchs 1 beziehungsweise dem des Anspruchs 6.

Zum Herstellen derartiger Solarzellenstring ist es bekannt, zum Verlöten beziehungsweise Schmelzen des Lötzins, beispielsweise Heißluft, Infrarot-Bestrahlung oder einen elektrisch beheizten Lötstempel zu verwenden. Das letztere ist bei einem Verfahren zum Herstellen eines Solarzellenbandes aus der EP 1 291 929 A1 bekannt geworden. Dabei wird im allgemeinen mit einer Blei-Zinn-Legierung gearbeitet. Nachteilige Auswirkung bei der Verwendung der vorgenannten elektrisch beheizten Lötstempel ergeben sich dabei insoweit, als durch das Oxidieren des Lötzinns sich Ablagerungen am Lötstempel bilden, die diesen zusetzen können. Inzwischen geht die Tendenz beim Löten jedoch zu einem bleifreien Lötzinn, was zu einer Erhöhung der Schmelztemperatur gegenüber bisher um ca. 30°C bis 40°C führt. Dies führt zu einer Erhöhung der notwendigen Schmelztemperatur, was wiederum die Gefahr von Ablagerungen am Lötstempel und dessen Zusetzen erhöht.

Aufgabe der vorliegenden Erfindung ist es deshalb, ein Verfahren und eine Vorrichtung zum Herstellen eines Solarzellenstring der eingangs genannten Art zu schaffen, bei dem beziehungsweise bei der ein Zusetzen der Schmelz- bzw. Lötvorrichtung und damit eine verschlechterte Wärmeübertragung von der Lötvorrichtung zu den zu verlötenden Bauteilen vermieden ist.

Zur Lösung dieser Aufgabe sind bei einem Verfahren und einer Vorrichtung zum Herstellen eines Solarzellenstring der eingangs genannten Art die im Anspruch 1 beziehungsweise die im Anspruch 6 angegebenen Merkmale vorgesehen.

Durch die erfindungsgemäßen Maßnahmen des berührungslosen induktiven Lötens beziehungsweise Schmelzens des Lötzinns zum Verlöten der betreffenden Bauteile ist eine Verschmutzung des Lötkopfes des Induktors vermieden, so dass die Wärmeübertragung in stets gleichbleibender Weise erfolgen kann. Die induktive Erwärmung mittels Hochfrequenz vermeidet ein langes Aufheizen, wie es bei elektrisch beheizbaren Stempeln der Fall ist. Außerdem kann durch Ausgestaltung des Induktors beziehungsweise dessen Hochfrequenzteil eine genauere Dosierung der Energiezuführung erreicht werden.

Vorteilhafte Ausgestaltungen des Verfahrens zum Herstellen eines Solarzellenstring ergeben sich aus den Merkmalen eines oder mehrerer der Ansprüche 2 bis 5.

Bei einer bevorzugten Ausführungsform der Vorrichtung vorliegender Erfindung ist gemäß den Merkmalen des Anspruchs 7 der Induktor oberhalb der Solarzellenanordnung plaziert. Dabei ist es zweckmäßig, die Merkmale nach Anspruch 8 vorzusehen, weil dadurch der Induktor gleichzeitig als Niederhalter beim Induktionslötprozess wirken kann. Dies spart zumindest ein Bauelement.

Zweckmäßigerweise sind ferner die Merkmale nach Anspruch 9 vorgesehen.

Alternativ kann der Induktor gemäß den Merkmalen des Anspruchs 10 unterhalb der Solarzellenanordnung plaziert sein, was allerdings zu konstruktivem Mehraufwand führen kann. Hierbei können die Merkmale nach Anspruch 11 und/oder 12 vorgesehen sein.

Vorteilhafte Ausgestaltungen des Induktors im Hinblick auf die Anordnung von zwei parallelen Lötbändern auf bzw. unter den Solarzellen ergeben sich aus den Merkmalen eines oder mehrerer der Ansprüche 13 bis 16. Dabei ist das Induktionsteil bevorzugt als abgekröpfter Induktionsstab derart ausgebildet, dass dieser nach Art einer halben Windung ausgebildet ist.

Um eine Begrenzung einer unmittelbaren Wärmeübertragung vom Induktor auf das Lötband oder die Lötbänder und die Solarzellen zu erreichen, sind die Merkmale gemäß Anspruch 17 vorgesehen. Dies führt zu einer weiteren Verbesserung des an sich berührungslosen Induktionslöten.

Weitere Einzelheiten der Erfindung sind der folgenden Beschreibung zu entnehmen, in der die Erfindung anhand des in der Zeichnung dargestellten Ausführungsbeispieles näher beschrieben und erläutert ist.

Es zeigen:
- Figur 1: in schematischer Darstellung eine Draufsicht auf eine Vorrichtung zum Herstellen eines Solarzellenstring gemäß einem bevorzugten Ausführungsbeispiel vorliegender Erfindung und
- Figur 2: eine Seitenansicht gemäß Pfeil II der Figur 1.

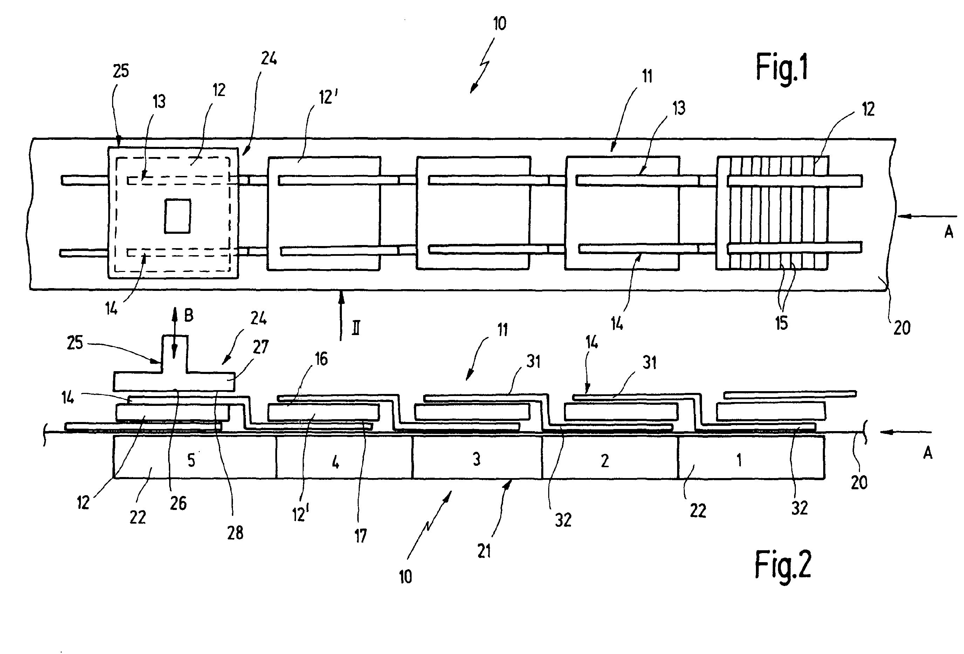

Die in der Zeichnung dargestellte Vorrichtung 10 sowie das mit dieser Vorrichtung 10 durchgeführte Verfahren dienen zum Herstellen eines Solarzellenstring, der aus mehreren in einer Reihe hintereinander angeordneten Solarzellen 12, insbesondere Siliziumzellen, die üblicherweise eine quadratische dünne Struktur besitzen, und aus parallel angeordneten Lötbändern 13 und 14. Üblicherweise ist jede Solarzelle 12, die mit querverlaufenden dünnen metallischen und aufgedruckten Stromsammlern 15 versehen ist, mit zwei an Seitenbereichen längsverlaufenden Lötbändern 13 und 14 als sogenannte Busbar bestückt. Diese Lötbänder 13 und 14 verlaufen längs der Oberseite 16 der Solarzellen 12, sind am Ende zur benachbarten Solarzelle 12' abgekröpft und verlaufen weiter längs der Unterseite 17 der benachbarten Solarzelle 12'. Es gilt nun, diese Lötbänder 13 und 14 jeweils an der Oberseite 16 der einen Solarzelle 12 einschließlich an deren Stromsammler 15 und an der Unterseite 17 der benachbarten Solarzelle 12' fest zu löten. Hierzu sind die Lötbänder 13 und 14, die beispielsweise als Kupfer-Band ausgebildet sind, mit Lötzinn versehen, also verzinnt. Eine derartige Solarzellenanordnung 11 gemäß den Figuren 1 und 2 wird mit Hilfe des erfindungsgemäßen Induktionslöt-Verfahrens und der erfindungsgemäßen Induktionslöt-Vorrichtung zu dem Endprodukt eines Solarzellenstrings. Mehrere solcher Solarzellenstrings ergeben elektrisch parallel geschaltet ein Voltaikpaneel.

Die beschriebene Solarzellenanordnung 11 aus einer Vielzahl von hintereinander angeordneten Solarzellen 12 und einer Vielzahl von noch unverbundenen Lötbändern 13 und 14 wird einem Förderband 20, das in Richtung des Pfeiles A getaktet oder kontinuierlich bewegt wird, zugeführt. Unterhalb des Förderbandes 20 ist eine Vorheizeinrichtung 21 angeordnet, die aus mehreren, beim Ausführungsbeispiel fünf in Richtung des Pfeiles A hintereinander angeordneten Vorheizzonen 22 (22₁ bis 22₅) besteht. Diese Vorheizzonen 22 dienen zum schonenden und gleichmäßigen Erwärmen der einzelnen Solarzellen 12 und deren Lötbänder 13 und 14 der Anordnung 11 von einer Umgebungsanfangstemperatur bis zu einer Temperatur unterhalb der Schmelztemperatur des verwendeten Lötzinns. Die einzelnen Vorheizzonen 22 können in nicht dargestellter Weise elektrisch beheizbare Heizplatten besitzen oder in Form von Heiztunnelabschnitten mit Infrarot-, Warmluft- oder dgl. Vorheizung ausgebildet sein. Die Längenausdehnung der Vorheizzonen 22 in Richtung des Pfeiles A entspricht etwa der entsprechenden Abmessung einer Solarzelle 12. Entsprechendes gilt für die Breite der Vorheizzonen 22 im Verhältnis zur Breite der Solarzellen 12. Das Förderband 20 ist beispielsweise ein Teflonband, unterhalb dem unmittelbar die Vorheizzonen 22 angeordnet sind. Die Vorheizzonen 22 der Vorheizeinrichtung 21 sind gegenüber dem Förderband 20 ortsfest angeordnet.

Im Bereich beziehungsweise oberhalb der in Bewegungsrichtung A letzten Vorheizzone 22₅ ist eine Induktionslötvorrichtung 24 mit einem Induktor 25 angeordnet. Die Unterseite 26 des Induktorkopfes 27 ist mit einem schlecht wärmeleitenden Material, beispielsweise in Form eines Keramikplättchens 28 belegt, das eine Dicke von etwa 2 mm aufweist. Der Induktor 25 mit seinem Kopf 27 ist in Richtung des Doppelpfeiles B gemäß Figur 2 auf und ab bewegbar, so dass der Induktorkopf 27 während des Induktionslötprozesses gleichzeitig als auf die zu verlötenden Bauteile 13, 12, 14 drückender Niederhalter Verwendung finden kann.

Der Induktor 25 besitzt in nicht im einzelnen dargestellter Weise einen Hochfrequenzgenerator, eine Wasserkühlung und dergleichen. Ein Induktionsteil des Induktors 25, das bei anderen Anwendungen beispielsweise als Induktionsspule ausgebildet ist, ist gemäß vorliegender Erfindung ein Induktionsstab, beispielsweise aus Kupfer, der umfangsseitig abgekröpft ist und eine sogenannte Spule mit halber Windung darstellt. Dieser Induktionsstab ist in nicht dargestellter Weise oberhalb und unmittelbar über einem Lötband 13 oder 14 beziehungsweise Busbar angeordnet. Der Induktionsstab hat im Wesentlichen dieselben Abmessungen wie die Abschnitte 31, 32 des Lötbandes 13 bzw. 14 auf der Oberseite 16 und der Unterseite 17 der Solarzelle 12. Der Induktorkopf 27 kann entweder so ausgebildet sein, dass er die Abschnitte 31 und 32 nur eines der Lötbänder 13, 14 abdeckt, oder so breit ausgebildet sein, dass er die Abschnitte 31, 32 beider paralleler Lötbänder 13 und 14 überdeckt. Jedenfalls ist jedem der beiden parallelen Lötbänder 13 und 14 ein einziger Induktionsstab zugeordnet.

Gemäß einer nicht dargestellten Ausführungsform ist der Induktor nicht in Kombination als Niederhalter oberhalb der Anordnung 11 sondern unterhalb der Anordnung 11 angeordnet, wobei oberhalb der Anordnung 11 zusätzlich ein Gegenhalter vorgesehen sein muss. Dabei ist es dann zweckmäßig, einen solchen Induktor mit separatem Gegenhalter in Richtung A nach der letzen Vorheizzone 22₅ anzuordnen.

Die einzelnen mit Hilfe der Vorrichtung 10 durchgeführten Verfahrensschritte sind folgende. Die Solarzellenanordnung 11 wird in der in der Zeichnung dargestellten Weise beispielsweise auf einer Zuführeinheit zusammengesetzt. Dabei sind die Lötbänder 13 und 14 zuvor in den betreffenden Berührungsabschnitten 31, 32 mit den Solarzellen 12, 12' mit einem bleifreien Lötzinn verzinnt, durch ein Flußbad gezogen, durch Erwärmung getrocknet und dann entsprechend gerichtet und gesickt worden. Diese Anordnung 11 wird dem Förderband 20 zugeführt, das mit einer Taktzeit von beispielsweise von etwa 6 bis 7 Sekunden bewegt wird. Die Taktbewegung des Förderbandes 20 erfolgt in der Weise, dass jeweils eine der Solarzellen 12, 12' mit den betreffenden Abschnitten 31, 32 der Lötbänder 13 und 14 über einer Vorheizzone 22 der Vorheizeinrichtung 21 zum Vorheizen kurz verweilt, wobei hier über fünf Vorheizzonen 22₁ bis 22₅ der betreffende Anordnungsabschnitt 11' aus Solarzelle 12 und Lötbänder 13, 14 auf beispielsweise etwa 170°C und damit unterhalb der Schmelztemperatur des Lötzinns erwärmt wird. In Abstimmung mit dieser Taktbewegung erfolgt das Induktionslöten mit Hilfe des Induktors 25, der entsprechend dem Stillstand des Förderbandes 20 in Richtung des Pfeiles B auf den jeweiligen Anordnungsabschnitt 11' zubewegt wird, diesen auf Schmelztemperatur des Lotes bringt gebracht und wieder zurückbewegt wird. Die Induktionslötprozess dauert etwa ein bis zwei Sekunden. Danach erfolgt eine Abkühlung der auf diese Weise induktionsgelöteten Bauteile 12, 13, 14. Die Taktung erfolgt bei einer Solarzellenanordnung 11 so lange, bis alle Solarzellen 12, 12' mit den betreffenden Abschnitten 31, 32 der Lötbänder 13 und 14 zu einem Solarzellenstring verlötet sind.

Gemäß einem weiteren Verfahren kann das Förderband 20 kontinuierlich bewegt werden, was beispielsweise zu einer Verlängerung der einzelnen Vorheizzonen 22 in Richtung des Pfeiles A führen kann und einer hin- und hergehenden Bewegung des Induktors 25, dessen einer Bewegungsabschnitt beim Induktionslöten mit der Förderbandbewegung übereinstimmt.

Es versteht sich, dass bei entsprechender Breite des Förderbandes 20 auch mehrere nebeneinander angeordnete Solarzelleanordnungen 11 vorgesehen sein können, die von mehreren parallelen Induktoren 25 bedient werden.

## Patentansprüche

1. Verfahren zum Herstellen eines Solarzellenstring aus mehreren aneinander gereihten, mit Lötbändern (13, 14) elektrisch in Reihe geschalteten und mechanisch verbundenen Solarzellen (12), insbesondere Siliziumzellen, bei dem die Lötbänder (13, 14) und an ihren, den Solarzellen (12) zugewandten Flächen mit Lötzinn überzogen abwechselnd auf die Oberseite (16) und auf die Unterseite (17) zweier benachbarter Solarzellen (12) gelegt werden und bei dem die so vorbereitete Solarzellenanordnung (11) über eine oder mehrere Vorheizzonen (22) geführt und am Ende zu einem Solarzellenstring verlötet wird, **dadurch gekennzeichnet, dass** die Lötbänder (13, 14) und die Solarzellen (12) durch Induktionslöten miteinander verbunden werden.

2. Verfahren nach Anspruch 1, **dadurch gekennzeichnet, dass** die Solarzellenanordnung (11) über die Vorheizzonen (22) getaktet geführt wird.

3. Verfahren nach Anspruch 2, **dadurch gekennzeichnet, dass** eine Taktzeit von etwa sechs bis sieben Sekunden gewählt wird.

4. Verfahren nach Anspruch 1, **dadurch gekennzeichnet, dass** die Solarzellenanordnung (11) im Durchlauf über die Vorheizzonen (22) geführt wird.

5. Verfahren nach mindestens einem der vorhergehenden Ansprüche, **dadurch gekennzeichnet, dass** der Induktionslötprozess über eine Zeit von ca. ein bis zwei Sekunden durchgeführt wird.

6. Vorrichtung (10) zum Herstellen eines Solarzellenstring aus mehreren aneinandergereihten, mit Lötbändern (13, 14) elektrisch in Reihe geschalteten und mechanisch verbundenen Solarzellen (12), insbesondere Siliziumzellen, mit einem Förderband (20), auf dem eine Solarzellenanordnung (11) aus aufgereihten Solarzellen (12) und abwechselnd auf deren Oberseite (16) und deren Unterseite (17) angeordneten und mit Lötzinn überzogenen Lötbänder (13, 14) längs bewegbar ist, mit einer Vorheizeinrichtung (21) bestehend aus zwei oder mehr Vorheizzonen (22), die ortsfest unterhalb und längs des Förderbandes (20) angeordnet sind, und mit einer Lötwärmequelle am Ende der Vorheizeinrichtung (21), **dadurch gekennzeichnet, dass** die Lötwärmequelle durch einen Induktor (25) einer Induktionslötvorrichtung gebildet ist.

7. Vorrichtung nach Anspruch 6, **dadurch gekennzeichnet, dass** der Induktor (25) oberhalb der Solarzellenanordnung (11) angeordnet ist.

8. Vorrichtung nach Anspruch 7, **dadurch gekennzeichnet, dass** der Induktor (25) gleichzeitig als bewegbarer Niederhalter ausgebildet ist.

9. Vorrichtung nach Anspruch 7 oder 8, **dadurch gekennzeichnet, dass** der Induktor (25) über der in Förderbandrichtung letzten Vorheizzone (22) angeordnet ist.

10. Vorrichtung nach Anspruch 6, **dadurch gekennzeichnet, dass** der Induktor (25) unterhalb der Solarzellenanordnung (11) bzw. Förderbandes (20) angeordnet ist.

11. Vorrichtung nach Anspruch 10, **dadurch gekennzeichnet, dass** der Induktor (25) nach der in Förderbandrichtung letzten Vorheizzone (22) angeordnet ist.

12. Vorrichtung nach Anspruch 10 oder 11, **dadurch gekennzeichnet, dass** oberhalb des Solarzellenanordnung (11) ein beweglicher Niederhalter angeordnet ist.

13. Vorrichtung nach mindestens einem der Ansprüche 6 bis 12, **dadurch gekennzeichnet, dass** bei mit jeweils zwei parallel angeordneten Lötbändern (13, 14) versehenen benachbarten Solarzellen (12) für jedes Lötband (13, 14) ein Induktionsteil des Induktors (25) vorgesehen ist.

14. Vorrichtung nach Anspruch 13, **dadurch gekennzeichnet, dass** der Induktor (25) mit zwei parallelen Induktionsteilen versehen ist.

15. Vorrichtung nach Anspruch 14, **dadurch gekennzeichnet, dass** das Induktionsteil durch einen Induktionsstab gebildet ist.

16. Vorrichtung nach Anspruch 15, **dadurch gekennzeichnet, dass** der Induktionsstab beidendig und/oder beidlängsseitig abgebogen oder abgekröpft ist.

17. Vorrichtung nach mindestens einem der Ansprüche 6 bis 16, **dadurch gekennzeichnet**, das zwischen der Unterseite (26) des Induktors (25) und dem zugewandten Lötband (13, 14) ein Wärmeisolierplättchen (28) von vorzugsweise etwa 2 mm Dicke angeordnet ist.
